(19)

Europäisches
Patentamt
European
Patent Office
Office européen
des brevets

(11) **EP 2 765 592 B1**

(12) **EUROPEAN PATENT SPECIFICATION**

(45) Date of publication and mention
of the grant of the patent:
**24.07.2019   Bulletin 2019/30**

(51) Int Cl.:
*H01J 37/32* (2006.01)          *H05H 1/24* (2006.01)

(21) Application number: **14154624.2**

(22) Date of filing: **11.02.2014**

(54) **Homogenous plasma chemical reaction device**

Chemische Reaktionsvorrichtung für homogenes Plasma

Dispositif de réaction chimique au plasma homogène

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **11.02.2013   US 201361763233 P
27.01.2014   US 201414164785**

(43) Date of publication of application:
**13.08.2014   Bulletin 2014/33**

(73) Proprietor: **COLORADO STATE UNIVERSITY
RESEARCH FOUNDATION
Fort Collins, CO 80522 (US)**

(72) Inventors:
 • **Collins, George J.
  Fort Collins, CO Colorado 80524 (US)**
 • **Koo, Il-Gyo
  Daegu 704910 (KR)**
 • **Youn, Heesang
  Cheonan City Choongnam (KR)**
 • **Choi, Myeong Yeol
  Fort Collins, CO Colorado 80525 (US)**
 • **Almgren, Carl W.
  Fort Collins, CO Colorado 80526 (US)**

(74) Representative: **Soames, Candida Jane et al
Maschio & Soames IP Limited
30 Carlton Crescent
Southampton SO15 2EW (GB)**

(56) References cited:
  **EP-A1- 1 978 038          WO-A1-2010/146438
  WO-A1-2011/123125     US-A1- 2011 101 862**

 • **PARK G Y ET AL: "Invited
  Review;Atmospheric-pressure plasma sources
  for biomedical
  applications;Atmospheric-pressure plasma
  sources for biomedical applications", PLASMA
  SOURCES SCIENCE AND TECHNOLOGY,
  INSTITUTE OF PHYSICS PUBLISHING, BRISTOL,
  GB, vol. 21, no. 4, 6 June 2012 (2012-06-06), page
  43001, XP020227430, ISSN: 0963-0252, DOI:
  10.1088/0963-0252/21/4/043001**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 765 592 B1

## Description

## BACKGROUND

*Technical Field*

The present disclosure relates to plasma devices and processes for surface processing, removal or deposition of biological or other materials. More particularly, the disclosure relates to an apparatus and method for generating and directing chemically reactive, plasma-generated species in a plasma device along with excited-state species (e.g., energetic photons) that are specific to the selected ingredients.

*Background of Related Art*

Electrical discharges in dense media, such as liquids and gases at or near atmospheric pressure, can, under appropriate conditions, result in plasma formation. Plasmas have the unique ability to create large amounts of chemical species, such as ions, radicals, electrons, excited-state (e.g., metastable) species, molecular fragments, photons, and the like. The plasma species may be generated in a variety of internal energy states or external kinetic energy distributions by tailoring plasma electron temperature and electron density. In addition, adjusting spatial, temporal and temperature properties of the plasma creates specific changes to the material being irradiated by the plasma species and associated photon fluxes. Plasmas are also capable of generating photons including vacuum ultraviolet photons that have sufficient energy to initiate photochemical and photocatalytic reaction paths in biological and other materials that are irradiated by the plasma.

## SUMMARY

Plasmas have broad applicability to provide alternative solutions to industrial, scientific and medical needs, especially workpiece surface processing at low temperature. Plasmas may be delivered to a workpiece, thereby affecting multiple changes in the properties of materials upon which the plasmas impinge. Plasmas have the unique ability to create large fluxes of radiation (e.g., ultraviolet), ions, photons, electrons and other excited-state (e.g., metastable) species which are suitable for performing material property changes with high spatial, material selectivity, and temporal control. Selective plasma may also remove a distinct upper layer of a workpiece but have little or no effect on a separate underlayer of the workpiece or it may be used to selectively remove a particular tissue type from a mixed tissue region or selectively remove a tissue with minimal effect to adjacent organs of different tissue type, e.g., removal of extra cellular matrix.

One suitable application of the unique chemical species is to drive non-equilibrium or selective chemical reactions at or within the workpiece to provide for selective removal of only certain types of materials. Such selective processes are especially sought in biological tissue processing (e.g., mixed or multi-layered tissue), which allows for cutting and removal of tissue at low temperatures with differential selectivity to underlayers and adjacent tissues. This is particularly useful for removal of extra cellular metrices, biofilms, mixtures of fatty and muscle tissue, and debridement of surface layers.

Examples of plasma systems and methods for such applications are disclosed in US 2011/0101862 A1 and WO 2011/123125 A1.

The plasma species are capable of modifying the chemical nature of tissue surfaces by breaking chemical bonds, substituting or replacing surface-terminating species (e.g., surface functionalization) through volatilization, gasification or dissolution of surface materials (e.g., gas and liquid base etching). With proper techniques, material choices and conditions, one can selectively remove one type of tissue entirely without affecting a nearby different type of tissue. Controlling plasma conditions and parameters (including S-parameters, V, I, $\Theta$, and the like) allows for the selection of a set of specific plasma particles, which, in turn, allows for selection of chosen chemical pathways for material removal or modification as well as selectivity of removal of desired tissue type. The present disclosure provides a system and method for creating plasma under a broad range of conditions including tailored geometries, various plasma feedstock media, number and location of electrodes and electrical excitation parameters (e.g., voltage, current, phase, frequency, pulse condition, etc.) all of which affect selectivity of the plasma to the plasma irradiated work piece.

The supply of electrical energy that ignites and sustains the plasma discharge is delivered through substantially conductive electrodes that are capacitively or inductively coupled with the ionizable media and other plasma feedstocks. The present disclosure also provides methods and apparatus that utilize specific electrode structures that improve and enhance desirable aspects of plasma operation such as higher electron temperature, greater catalytic effect on feedstocks and higher amount of secondary emission. In particular, the present disclosure provides porous media both for controlled release of chemical reactants and for holding catalytic materials.

The plasma includes electrons, radicals, metastable species and photons that drive the reaction at the workpiece, including energetic electrons delivered thereto. Controlling plasma conditions and parameters allows for selection of a set of specific particles, which, in turn, allows for selection of chemical pathways for material removal or modification as well as selectivity of removal of desired tissue type. The present disclosure also provides a system and method for generating plasmas that operate at or near atmospheric pressure. The plasmas include electrons that drive reactions at material surfaces in concert with other plasma species. Electrons delivered to the material surface can initiate a variety of processes including bond scission, which enables volatilization in subsequent reactions. Tailored plasmas may enhance polymerization of monomers. The electron-driven reactions act synergistically with associated fluxes to achieve removal rates of material greater than either of the reactions acting alone.

According to the present invention, there is provided a plasma system according to claim 1 and methods for generating plasma according to claims 7 and 9. Further embodiments of the present invention are disclosed in the dependent claims.

According to one embodiment of the present disclosure, a plasma system is disclosed. The system includes: a plasma device including at least one electrode; an ionizable media source coupled to the plasma device and configured to supply ionizable media thereto; a precursor source configured to supply at least one precursor feedstock to the plasma device, wherein the at least one precursor feedstock includes at least one catalyst material; and a power source coupled to the inner and outer electrodes and configured to ignite the ionizable media and the at least one precursor feedstock at the plasma device to form a plasma effluent.

According to one aspect of the above embodiment, the at least one electrode is formed from a metal alloy selected from the group consisting of an aluminum alloy and a titanium alloy.

According to one aspect of the above embodiment, the at least one catalyst material is selected from the group consisting of ruthenium, rhodium, palladium, silver, osmium, iridium, platinum, gold, nickel, copper, cobalt, iron, and oxides and bimetal combinations thereof.

According to one aspect of the above embodiment, the at least one precursor feedstock is selected from the group consisting of a solution, a suspension and a mixture of the at least one catalyst material.

According to one aspect of the above embodiment, the precursor source includes a nebulizer configured to form an aerosol spray of the at least one precursor feedstock.

According to one aspect of the above embodiment, the plasma device includes: an outer electrode having a substantially cylindrical tubular shape defining a lumen therethrough; and an inner electrode coaxially disposed within lumen, the inner electrode having a substantially cylindrical tubular shape.

According to one aspect of the above embodiment, the at least one catalyst material is formed as a plurality of particles.

According to one embodiment of the present disclosure, a method for generating plasma is disclosed. The method includes: supplying ionizable media to a plasma device; supplying at least one precursor feedstock to the plasma device, wherein the at least one precursor feedstock includes at least one catalyst material; and igniting the ionizable media and the at least one precursor feedstock at the plasma device to form a plasma effluent.

According to one aspect of the above embodiment, the method include nebulizing the at least one precursor feedstock to form an aerosol spray.

According to one aspect of the above embodiment, the at least one catalyst material is selected from the group consisting of ruthenium, rhodium, palladium, silver, osmium, iridium, platinum, gold, nickel, copper, cobalt, iron, and oxides and bimetal combinations thereof.

According to one aspect of the above embodiment, the at least one precursor feedstock is selected from the group consisting of a solution, a suspension and a mixture of the at least one catalyst material.

According to one aspect of the above embodiment, the at least one catalyst material is formed as a plurality of particles.

According to one embodiment of the present disclosure, a plasma device is disclosed. The plasma device includes at least one electrode; an ionizable media source coupled to the plasma device and configured to supply ionizable media thereto; a power source coupled to the inner and outer electrodes and configured to ignite the ionizable media at the plasma device to form a plasma effluent; a precursor source including a nebulizer configured to nebulize at least one precursor feedstock including at least one catalyst material to form an aerosol spray; and an applicator coupled to the precursor source, the applicator directing the aerosol spray into the plasma effluent.

According to one aspect of the above embodiment, the at least one electrode is formed from a metal alloy selected from the group consisting of an aluminum alloy and a titanium alloy.

According to one aspect of the above embodiment, the at least one catalyst material is selected from the group consisting of ruthenium, rhodium, palladium, silver, osmium, iridium, platinum, gold, nickel, copper, cobalt, iron, and oxides and bimetal combinations thereof.

According to one aspect of the above embodiment, the plasma device includes: an outer electrode having a substantially cylindrical tubular shape defining a lumen therethrough; and an inner electrode coaxially disposed within lumen, the inner electrode having a substantially cylindrical tubular shape.

According to one embodiment of the present disclosure, a method for generating plasma is disclosed. The method includes: supplying ionizable media to a plasma device; igniting the ionizable media at the plasma device to form a plasma effluent; nebulizing the at least one precursor feedstock to form an aerosol spray, wherein the at least one precursor feedstock includes at least one catalyst material; and supplying the aerosol spray through an applicator into the plasma effluent.

According to the present invention, the at least one catalyst material is selected from the group consisting of ruthenium, rhodium, palladium, silver, osmium, iridium, platinum, gold, nickel, copper, cobalt, iron, and oxides and bimetal combinations thereof.

According to one aspect of the above embodiment, the at least one precursor feedstock is selected from the group consisting of a solution, a suspension and a mixture of the at least one catalyst material.

According to one aspect of the above embodiment, the method further includes applying the aerosol spray to a workpiece prior to applying the plasma effluent thereto.

In embodiments of the various system and method aspects, the plasma device is utilizable as an electrosurgical pencil or other electrosurgical device for application of plasma to tissue.

In embodiments of the various system and method aspects, the plasma feedstock, which includes ionizable media and precursor feedstock, is so that, during operation, the precursor feedstock and the ionizable media are provided to the plasma device where the plasma feedstock is ignited to form plasma effluent.

In embodiments of the various system and method aspects, the catalyst material is material suitable for initiation of chemical reactions within the plasma effluent.

In embodiments of the various system and method aspects, the catalyst material includes noble metals.

In embodiments of the various system and method aspects, the catalyst material is provided as nano-particles, which may be suspended in a liquid.

In embodiments of the various system and method aspects, the precursor feedstock includes an aerosol spray including the liquid and the catalyst material. In a particular embodiment, the spray includes liquid particles (e.g., micro-droplets) including one or more catalyst materials, e.g. in nanoparticle form.

In embodiments of the various system and method aspects, the configuration is such that precursor feedstock including the catalyst material is mixed with the ionizable media and the mixture is ignited to form the plasma effluent, optionally wherein the catalyst material reacts with the liquid particles as well as the ionizable media.

In embodiments of the various method and system aspects, the configuration is such that the precursor feedstock including the catalyst material is supplied downstream of an ignition point of the plasma effluent.

In embodiments of the various system and method aspects, the catalyst material is for promoting generation of OH radicals in the plasma effluent.

In embodiments of the various system and method aspects, the catalyst material is for promoting generation of hydroxyl and/or nitrogen radicals in the plasma effluent.

In the method aspects, the method does not extend to applying the plasma effluent to tissue.

## BRIEF DESCRIPTION OF THE DRAWINGS

The accompanying drawings, which are incorporated in and constitute a part of this specification, illustrate exemplary embodiments of the disclosure and, together with a general description of the disclosure given above, and the detailed description of the embodiments given below, serve to explain the principles of the disclosure, wherein:

Fig. 1 is a schematic diagram of a plasma system according to an embodiment of the present disclosure;
Fig. 2 is a perspective, cross-sectional perspective view of the plasma device according an embodiment to the present disclosure;
Fig. 3 is a side, cross-sectional view of the plasma device of Fig. 2;
Fig. 4 is a schematic diagram of a nebulizer according to the present disclosure;
Fig. 5 is a schematic diagram of a plasma system according to another embodiment of the present disclosure;
Fig. 6 is a bar graph illustrating voltage and current of plasma generated according to an embodiment of the present disclosure;
Fig. 7 is a photograph of a cross-sectional tissue sample subjected to plasma treatment according to an embodiment of the present disclosure;
Fig. 8 is a graph illustrating hydroxyl emission spectra of plasma generated according to an embodiment of the present disclosure; and
Fig. 9 is a graph illustrating hydroxyl and nitrogen emission spectra of plasma generated according to an embodiment of the present disclosure.

## DETAILED DESCRIPTION

Plasmas are generated using electrical energy that is delivered as either direct current (DC) electricity or alternating current (AC) electricity, in either continuous or pulsed modes, at frequencies from about 0.1 hertz (Hz) to about 100 gigahertz (GHz), including radio frequency ("RF", from about 0.1 MHz to about 100 MHz) and microwave ("MW", from about 0.1 GHz to about 100 GHz) bands, using appropriate generators, electrodes, and antennas. Choice of excitation frequency, the workpiece, as well as the electrical circuit that is used to deliver electrical energy to the circuit affects many properties and requirements of the plasma. The performance of the plasma chemical generation, the gas or liquid feedstock delivery system and the design of the electrical excitation circuitry are interrelated -- as the choices of operating voltage, frequency and current levels, as well as phase, affect the electron temperature and electron density. Further, choices of electrical excitation and plasma device hardware also determine how a given plasma system responds dynamically to the introduction of new ingredients to the host plasma gas or liquid media. The corresponding dynamic adjustment of the electrical drive, such as via dynamic match networks or adjustments to voltage, current, or excitation frequency may be used to maintain controlled power transfer from the electrical circuit to the plasma.

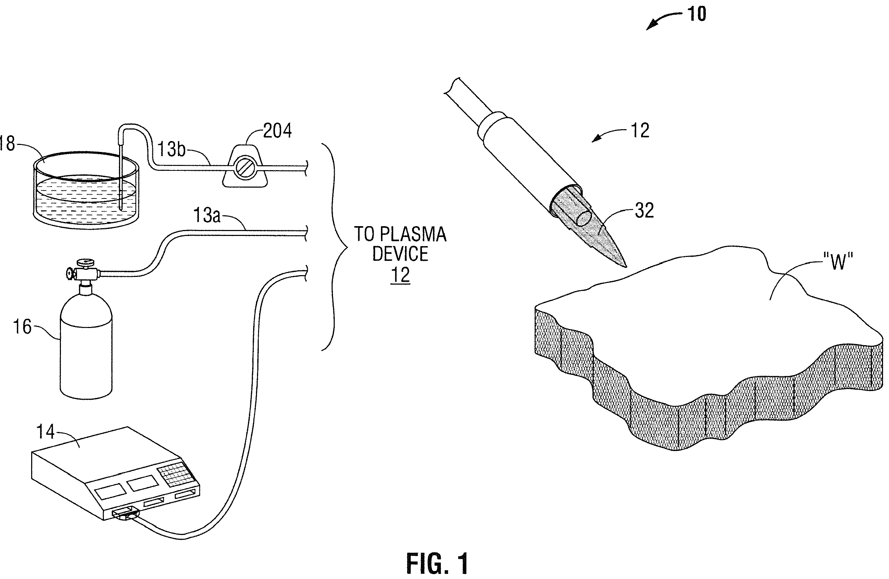

Referring initially to Fig. 1, a plasma system 10 is disclosed. The system 10 includes a plasma device 12 that is coupled to a power source 14, an ionizable media source 16 and a precursor or pre-ionization source 18. Power source 14 includes any suitable components for delivering power or matching impedance to plasma device 12. More particularly, the power source 14 may be any radio frequency generator or other suitable power source capable of producing electrical power to ignite and sustain the ionizable media to generate a plasma effluent 32. The plasma device 12 may be utilized as an electrosurgical pencil for application of plasma to tissue and the power source 14 may be an electrosurgical generator that is adapted to supply the device 12 with electrical power at a frequency from about 0.1 MHz to about 2,450 MHz and in another embodiment from about 1 MHz to about 160 MHz. The plasma may also be ignited by using continuous or pulsed direct current (DC) electrical energy or continuous or pulsed RF electrical energy or combinations thereof.

The precursor source 18 may include a bubbler or a nebulizer 204 configured to aerosolize precursor feedstocks prior to introduction thereof into the device 12. In embodiments, the precursor source 18 may also include a micro droplet or injector system capable of generating predetermined refined droplet volume of the precursor feedstock from about 1 femtoliter to about 1 nanoliter in volume. The precursor source 18 may also include a microfluidic device, a piezoelectric pump, or an ultrasonic vaporizer.

The system 10 provides a flow of plasma through the device 12 to a workpiece "W" (e.g., tissue). Plasma feedstocks, which include ionizable media and precursor feedstocks, are supplied by the ionizable media source 16 and the precursor source 18, respectively, to the plasma device 12. During operation, the precursor feedstock and the ionizable media are provided to the plasma device 12 where the plasma feedstocks are ignited to form plasma effluent 32 containing ions, radicals, photons from the specific excited species and metastables that carry internal energy to drive desired chemical reactions in the workpiece "W" or at the surface thereof. The feedstocks may be mixed upstream from the ignition point or midstream thereof (e.g., at the ignition point) of the plasma effluent, as shown in Fig. 1 and described in more detail below.

The ionizable media source 16 provides ionizable feedstock gas mix to the plasma device 12. The ionizable media source 16 is coupled to the plasma device 12 and may include a storage tank and a pump (not explicitly shown). The ionizable media may be a liquid or a gas such as argon, helium, neon, krypton, xenon, radon, carbon dioxide, nitrogen, hydrogen, oxygen, etc. and their mixtures, and the like, or a liquid. These and other gases may be initially in a liquid form that is gasified during application.

The precursor source 18 provides precursor feedstock to the plasma device 12. The precursor feedstock may be either in solid, gaseous or liquid form and may be mixed with the ionizable media in any state, such as solid, liquid (e.g., particulates, nanoparticles or droplets), gas, and the combination thereof. The precursor source 18 may include a heater, such that if the precursor feedstock is liquid, it may be heated into gaseous state prior to mixing with the ionizable media.

In one embodiment, the precursors may be any chemical species capable of forming reactive species such as ions, electrons, excited-state (e.g., metastable) species, molecular fragments (e.g., radicals) and the like, when ignited by electrical energy from the power source 14 or when undergoing collisions with particles (electrons, photons, or other energy-bearing species of limited and selective chemical reactivity) formed from ionizable media 16. More specifically, the precursors may include chemical compounds having various reactive functional groups, such as acyl halide, alcohol, aldehyde, alkane, alkene, amide, amine, butyl, carboxlic, cyanate, isocyanate, ester, ether, ethyl, halide, haloalkane, hydroxyl, ketone, methyl, nitrate, nitro, nitrile, nitrite, nitroso, peroxide, hydroperoxide, oxygen, hydrogen, nitrogen, and combination thereof. In embodiments, the chemical precursors may be water, halogenoalkanes, such as dichloromethane, tricholoromethane, carbon tetrachloride, difluoromethane, trifluoromethane, carbon tetrafluoride, and the like; peroxides, such as hydrogen peroxide, acetone peroxide, benzoyl peroxide, and the like; alcohols, such as methanol, ethanol, isopropanol, ethylene glycol, propylene glycol, alkalines such as NaOH, KOH, amines, alkyls, alkenes, and the like. Such chemical precursors may be applied in substantially pure, mixed, or soluble form.

The precursors and their functional groups as well as nanoparticles may be delivered to a surface to react with the surface species (e.g., molecules) of the workpiece "W." In other words, the functional groups may be used to modify or replace existing chemical surface terminations of the workpiece "W." The functional groups react readily with the surface species due to their high reactivity and the reactivity imparted thereto by the plasma. In addition, the functional groups are also reacted within the plasma effluent prior to delivering the plasma effluent to the workpiece.

Some functional groups generated in the plasma can be reacted *in situ* to synthesize materials that subsequently form a deposition upon the surface. This deposition may be used for stimulating healing, killing bacteria, and increasing hydrophilic or hydroscopic properties to minimize tissue sticking to the electrode or to other tissue. In addition, deposition of certain function groups may also allow for encapsulation of the surface to achieve predetermined gas/liquid diffusion (e.g., allowing gas permeation but preventing liquid exchange), to bond or stimulate bonding of surfaces, or to apply as a physically protective layer.

The ionizable media source 16 and the precursor source 18 and may be coupled to the plasma device 12 via tubing 13a and 13b, respectively. The tubing 13a and 13b may be combined into a single tubing (e.g., via a Y coupling) to deliver a mixture of the ionizable media and the precursor feedstock to the device 12 at a proximal end thereof. This allows for the plasma feedstocks, e.g., the precursor feedstocks, nanoparticles and the ionizable gas, to be delivered to the plasma device 12 simultaneously prior to ignition of the mixture therein.

In another embodiment, the ionizable media source 16 and the precursors source 18 may be coupled to the plasma device 12 via the tubing 13a and 13b at separate connections, such that the mixing of the feedstocks occurs within the plasma device 12 upstream from the ignition point. In other words, the plasma feedstocks are mixed proximally of the ignition point, which may be any point between the respective sources 16 and 18 and the plasma device 12, prior to ignition of the plasma feedstocks to create the desired mix of the plasma effluent species flux (e.g., particles/cm$^2$sec) for each specific surface treatment on the workpiece "W."

In a further embodiment, the plasma feedstocks may be mixed midstream, e.g., at the ignition point or downstream of the plasma effluent, directly into the plasma effluent 32. More specifically, the tubing 13a and 13b may be coupled to the device 12 at the ignition point, such that the precursor feedstocks and the ionizable media are ignited concurrently as they are mixed. It is also envisioned that the ionizable media may be supplied to the device 12 proximally of the ignition point, while the precursor feedstocks are mixed therewith at the ignition point.

In a further illustrative embodiment, the ionizable media may be ignited in an unmixed state and the precursors may be mixed directly into the ignited plasma effluent 32. Prior to mixing, the plasma feedstocks may be ignited individually. The plasma feedstock is supplied at a predetermined pressure to create a flow of the medium through the device 12, which aids in the reaction of the plasma feedstocks and produces the plasma effluent 32. The plasma effluent 32 according to the present disclosure is generated at or near atmospheric pressure under normal atmospheric conditions.

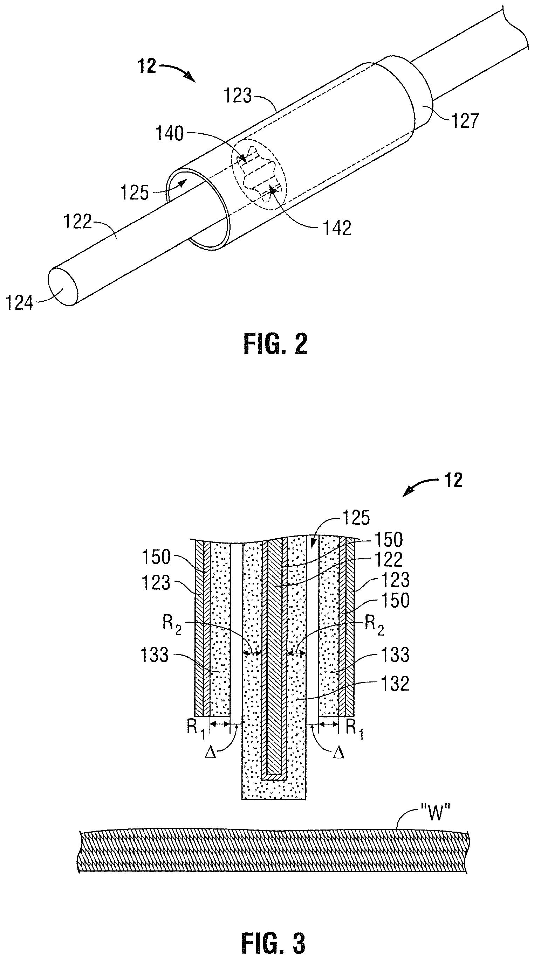

With reference to Figs. 2 and 3, the device 12 includes an inner electrode 122 disposed coaxially within an outer electrode 123. As shown in Fig. 2, the outer electrode 123 has a substantially cylindrical tubular shape having a lumen 125 defined therethrough. The inner electrode 122 has a substantially cylindrical shape (e.g., rod-shaped) having a closed distal portion 124. The electrodes 122 and 123 may be formed from a conductive material suitable for ignition of plasma such as metals and metal-ceramic composites. In one embodiment, the electrodes 122 and 123 may be formed from a conductive metal including a native oxide or nitride compound disposed thereon.

The device 12 also includes an electrode spacer 127 disposed between the inner and outer electrodes 122 and 123. The electrode spacer 127 may be disposed at any point between the inner and outer electrodes 122 and 123 to provide for a coaxial configuration between the inner and outer electrodes 122 and 123. The electrode spacer 127 includes a central opening 140 adapted for insertion of the inner electrode 122 therethrough and one or more flow openings 142 disposed radially around the central opening 140 to allow for the flow of ionizable media and precursors through the device 12. In embodiments, the electrode spacer 127 may be formed from a dielectric material, such as ceramic, to provide for capacitive coupling between the inner and outer electrodes 122 and 123.

The electrode spacer 127 may be frictionally fitted to the electrodes 122 and 123 to secure the inner electrode 122 within the outer electrode 123. In another embodiment, the electrode spacer 127 may be secured to the outer electrode 123 but be slidably disposed over the inner electrode 122. This configuration provides for longitudinal adjustment of the distal portion 124 of the inner electrode 122 relative to the outer electrode 123 to achieve a desired spatial relationship between the electrodes 122 and 123 (e.g., controlling the exposure of the distal portion 124 of the inner electrode 122).

In embodiments, the distal portion 124 of the inner electrode 122 may be extended past the distal end of the outer electrode 123. In another embodiment, the distal portion 124 of the inner electrode 122 may be retracted into the lumen 125, such that the distal portion 124 is fully enclosed by the outer electrode 123. In a further embodiment, the distal portion 124 of the inner electrode 122 may be flush with the distal end of the outer electrode 123.

One of the electrodes 122 and 123 may be an active electrode and the other may be a neutral (e.g., indifferent) or return electrode to facilitate in RF energy coupling through an isolation transformer (not shown) disposed within the generator 14 to provide electrical isolation with the workpiece "W." Each of the electrodes 122 and 123 are coupled to the power source 14 that drives plasma generation, such that the energy from the power source 14 may be used to ignite the plasma feedstocks flowing through the device 12. More specifically, the ionizable media and the precursors flow through the device 12 through the openings 142 and the lumen 125 (e.g., through the electrode spacer 127 and between the inner and outer electrodes 122 and 123). When the electrodes 122 and 123 are energized, the plasma feedstocks are ignited and form the plasma effluent 32 which is emitted from the distal end of the device 12 onto the workpiece "W."

As shown in Fig. 3, the inner electrode 122 and outer electrode 123 may include a coating 150 formed from an insulative or semiconductive material deposited as a film unto the inner conductor (e.g., atomic layer deposition) or as a dielectric sleeve or layer. The coating is disposed on the outer surface of the inner electrode 122 and on the inner surface of the outer electrode 123. In other words, the surfaces of the inner and outer electrodes 122 and 123 facing the lumen 125 include the coating 150. In one embodiment, the coating may cover the entire surface of the inner and outer electrodes 122 and 123 (e.g., outer and inner surface thereof, respectively). In another embodiment, the coating may cover only a portion of the electrodes 122 and 123.

The coating may be a nanoporous native oxide, or a native nitride of the metal from which the inner and outer electrodes are formed, or may be a deposited layer or a layer formed by ion implantation. In embodiments, the inner and outer electrodes 122 and 123 are formed from an aluminum alloy and the coating is aluminum oxide ($Al_2O_3$) or aluminum nitride (AlN). In another illustrative embodiment, the inner and outer electrodes 122 and 123 are formed from a titanium alloy and the coating is titanium oxide ($TiO_2$) or titanium nitride (TiN). In embodiments, the coating may also be a non-native metal oxide or nitride, such as zinc oxide ($ZnO_2$) and magnesium oxide (MgO). The coating may also be used to reduce tissue sticking to prevent tissue sticking to the electrode.

The inner and outer electrodes 122 and 123 and the coating 150 may also be configured as a heterogeneous system. The inner and outer electrodes 122 and 123 may be formed from any suitable electrode substrate material (e.g., conductive metal or a semiconductor) and the coating may be disposed thereon by various coating processes. The coating may be formed on the inner and outer electrodes 122 and 123 by exposure to an oxidizing environment, anodization, electrochemical processing, ion implantation, or deposition (e.g., sputtering, chemical vapor deposition, atomic layer deposition, etc.).

In another embodiment the coating on electrodes 122 and 123 may be different on each electrode and may serve separate purposes. One coating 150 (e.g., on the electrode 122) can be selected to promote increased secondary electron emission while coating on the other electrode (e.g., electrode 123) can be selected to promote specific chemical reactions (e.g., act as a catalyst).

In embodiments, the coating provides capacitive coupling between the inner and outer electrodes 122 and 123. The resulting capacitive circuit element structure provides a net negative bias potential at the surface of the inner and outer electrodes 122 and 123, which attracts the ions and other species from the plasma effluent. These species then bombard the coating 150 and release energetic electrons.

Materials having high secondary electron emission property, $\gamma$, in response to ion and/or photon bombardment are suitable for forming the coating 150. Such materials include insulators and/or semiconductors. These materials have a relatively high $\gamma$, where $\gamma$ repre-

sents the number of electrons emitted per incident bombardment particle. Thus, metals generally have a low $\gamma$ (e.g., less than 0.1) while insulative and semiconductor materials, such as metallic oxides have a high $\gamma$, from about 1 to about 10 with some insulators exceeding a value of 20. Thus, the coating 150 acts as a source of secondary emitted electrons.

Secondary electron emission, $\gamma$, may be described by the formula (1):

$$(1) \qquad \gamma = \Gamma_{secondary} / \Gamma_{ion}$$

In formula (1) $\gamma$ is the secondary electron emission yield or coefficient, $\Gamma_{secondary}$ is the electron flux, and $\Gamma_{ion}$ is the ion flux. Secondary emission occurs due to the impacts of plasma species (e.g., ions) onto the coating 150 when the ion impact collisions have sufficient energy to induce secondary electron emission, thus generating $\gamma$-mode discharges. Generally discharges are said to be in $\gamma$-mode when electron generation occurs at electrode surfaces (i.e., $\gamma > 1$) instead of in the gas (an $\alpha$-mode discharge). In other words, per each ion colliding with the coating 150, a predetermined number of secondary electrons are emitted. Thus, $\gamma$ may also be thought of as a ratio of the $\Gamma_{secondary}$ (e.g., the electron flux) and $\Gamma_{ion}$ (e.g., the ion flux).

These ion collisions with the surface of the coating 150, in turn, provide sufficient energy for secondary electron emission to generate $\gamma$ discharges. The ability of coating materials to generate $\gamma$ discharges varies with several parameters, with the most influence due to the choice of materials having a high $\gamma$ as discussed above. This property allows coating 150 to act as a source of secondary emitted electrons or as a catalytic material to enhance selected chemical reaction paths.

Over time the coating 150 may thin or be removed during the plasma operation. In order to maintain the coating 150 to continually provide a source of secondary emitted electrons, the coating 150 may be continually replenished during the plasma operation. This may be accomplished by adding species that reformulate the native coating on the inner and outer electrodes 122 and 123. In one embodiment, the precursor source 18 may provide either oxygen or nitrogen gas to the device 12 to replenish to oxide or nitride coating.

Secondary electron emission forms sheath layers 132 and 133 about the inner and outer electrodes 122 and 123, respectively. The sheath layers 132 and 133 have working ranges $R_1$ and $R_2$, which are representative of the thickness of energetic electron sheath layers 132 and 133 disposed about the inner and outer electrodes 122 and 123. In other words, ranges $R_1$ and $R_2$ indicate regions with a greatly increased concentration of electrons with relatively high energies that drive dissociation reactions in the gas phase. The coating 150 on electrodes 122 and/or 123 can increase or enhance

working ranges $R_1$ and $R_2$ of energetic secondary electrons. In particular, varying the thickness of the coating 150 can be used to adjust the working ranges $R_1$ and $R_2$. A gap distance $\Delta$ shows the zone where the concentration of energetic secondary electrons is relatively lower. Coating the electrodes, as discussed above, reduces gap distance $\Delta$. In some embodiments, distance $\Delta$ may be reduced to zero and/or working ranges $R_1$ and $R_2$ may overlap thereby creating an hollow cathode effect.

Formation of the sheath layers 132 and 133 is also controlled by the supply of the ionizable media and the precursors. Ionizable media and the precursors are selected that are relatively transparent to the energetic electrons released during secondary emission from the surface of the coating 150. As stated above, the plasma is generated at atmospheric pressure. Due to the increased entropy at such pressure, the generated electrons undergo a multitude of collisions in a relatively short period of time and space forming the sheath layers 132 and 133.

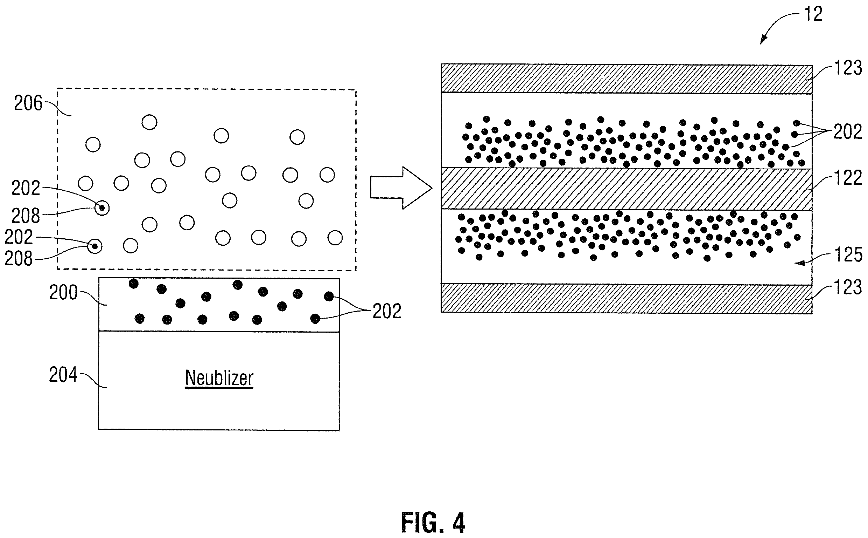

In embodiments, the precursor feedstocks may be a solution, a suspension or mixture of one or more catalyst materials 202 as shown in Fig. 4. The catalyst materials 202 may be any material suitable for initiation of the chemical reactions within the plasma effluent 32. Examples of suitable metals that can act as catalysts include noble metals, such as ruthenium, rhodium, palladium, silver, osmium, iridium, platinum, gold; metal catalysts, such as nickel, copper, cobalt, iron; metal oxide catalysts such as iron oxide, ruthenium oxide; photo catalysts such as titanium oxide, copper-iron loaded titanium oxide and silicone oxide, sodium tantalite with co-catalyst nickel oxide; bimetal catalysts such as platinum-ruthenium, platinum-gold, and combinations thereof. The catalyst materials 202 can be provided as a salt or organic compound, examples of which include metal halides, such as nickel chloride, platinum chloride, and combinations thereof.

In embodiments, the catalyst materials 202 may be particles (e.g., nano-particles) suspended in a liquid 200, which may be an aqueous solution of deionized water or solution of alcohol or a mixture thereof or any other suitable solvent. The liquid 200 is supplied to a nebulizer 204, as shown in Figs. 1 and 4, which forms an aerosol spray 206 including the liquid 200 and the catalyst materials 202. In particular, the spray 206 includes liquid particles (e.g., micro-droplets) 208 including one or more catalyst materials 202.

The nebulizer 204 may be one built by Analytica of Branford or may alternatively be a Burgener nebulizer (e.g., an Ari Mist model), in which the electrospray is used as an atomizer and is not energized electrically. The spray 206 is then supplied to the plasma device 12 at any point (e.g., upstream or midstream of the ignition point) as discussed above. In particular, as the spray 206 is injected into the lumen 125, within which the spray 206 is mixed with the ionizable media and the mixture is ignited to form the plasma effluent 32 as the catalyst materials 202 react with the liquid particles 208 as well as the ionizable media. The resulting plasma particles within the lumen 125 induce a variety of chemical reactions in the feedstocks and ionizable media including dissociation into highly specific reactive radicals as opposed to others, e.g., less reactive, ground state species. The flow of the ionizable media, feedstocks and the spray 206 through the lumen 125 enables transport of plsma-generated species out of the device 12 to impinge on the surface of the workpiece "W."

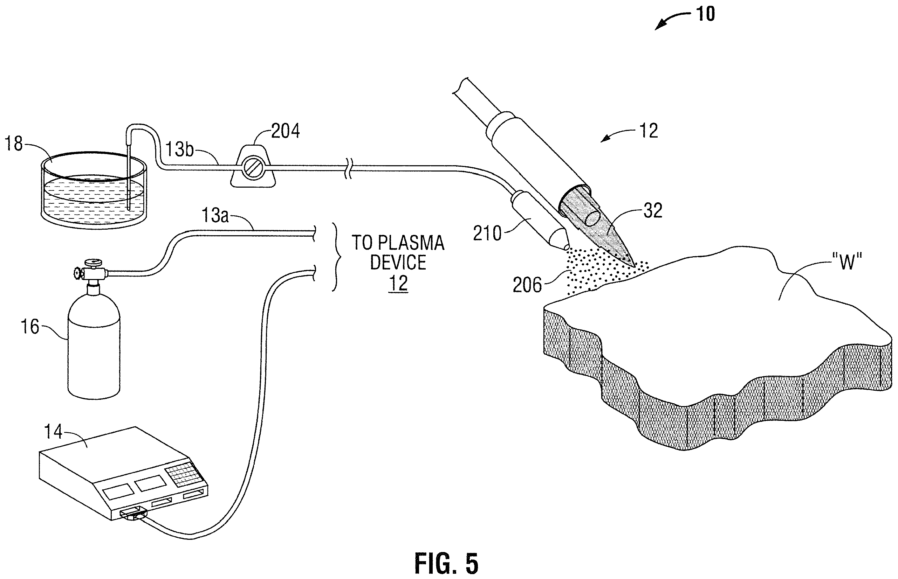

In embodiments, the catalyst materials 202 may be supplied downstream of the ignition point of the plasma effluent 32, i.e., directly into the plasma effluent 32 after ignition. With reference to Figs. 4 and 5, the nebulizer 204 atomizes or otherwise nebulizes the liquid 200 including the catalyst materials 202 to form the spray 206. The spray 206 may then be applied via an aerosol applicator 210, which may be an ultrasonic applicator or a nozzle-type device. In embodiments, the applicator 210 may include a nebulizer thereby obviating the need for a stand-alone nebulizer 204. The applicator 210 may be coupled to the plasma device 12 allowing the spray 206 to be applied adjacent the plasma effluent 32.

The spray 206 includes liquid particles (e.g., micro-droplets) 208 including one or more catalyst materials 202. The spray 206 is then supplied to the plasma device 12 directly into the plasma effluent 32. The catalyst materials 202 induce a variety of chemical reactions in the plasma effluent 32 between the feedstocks and ionizable media such as dissociation into highly specific reactive radicals as opposed to others, e.g., less reactive, ground state species. The flow of the ionizable media, feedstocks of the plasma effluent 32 through the lumen 125 enables transport of plasma-generated species out of the device 12 to mix with the spray 206 downstream. The flowing plasma effluent 32 and the spray 206 then mix on the surface of the workpiece "W" with an increase in radical species densities at the surface.

In embodiments, the spray 206 may be applied onto the surface of the workpiece "W" concurrently or prior to application of the plasma device 12, thereby depositing the catalyst materials 202 on the surface of the workpiece "W," which then reacts with the plasma effluent 32 as plasma is applied to the workpiece "W." The spray 206 may be applied to the workpiece "W" in a predetermined pattern to provide for patterned surface fictionalization, e.g., in various patterns to provide for selective plasma application. More specifically, plasma coming in contact with the patterned application of the catalyst materials 202 reacts at different rates at the surface of the workpiece "W" resulting in higher surface removal when compared with material removal lacking the catalyst materials 202.

Chemical reactions, including those within the plasma effluent 32, are guided by two main physical and chemical concepts: thermodynamics and chemical kinetics. The thermodynamics values depend on the gas temperature of reaction media and surface of the workpiece "W" as well as the electron energy and electron density of the plasma effluent 32. Chemical kinetics depend on the concentration of the reactant species (e.g., ionizable media and precursor feedstocks) and/or surface density as well as the concentration of the reactive species impinging on the surface. Excited state radical reactions are generally faster chemical reactions than those involving ground state reactants due to internal energies. Therefore, increasing the concentration of excited radicals increases the electron energy and density of the plasma effluent 32. Adding catalyst materials 220 into the plasma effluent 32 modifies chemical reaction temperature conditions and the relative reactive chemical species concentrations. More specifically, catalysts reduce reaction temperature that drive key chemical reactions, resulting in increased chemical reaction rates at fixed temperature. In addition, catalysts promote selective chemical reactions as compared to other chemical pathways resulting in increased densities of specific radicals, which subsequently impinge on the surface of the workpiece "W." Specific radical fluxes subsequently impinge on the surface of the workpiece "W" enabling selective alteration of the surface, e.g., affecting first type of tissue without affecting second type of tissue. Effectiveness of the catalyst is controlled by adjusting the surface area e.g., size of the nano-particles, of the catalyst materials 220 as well as the location thereof within the lumen 125. The higher surface area results in an increase of reaction sites.

The following Examples are being submitted to illustrate embodiments of the present disclosure. These Examples are intended to be illustrative only and are not intended to limit the scope of the present disclosure. Also, parts and percentages are by weight unless otherwise indicated. As used herein, "room temperature" refers to a temperature of from about 20 ° C to about 30° C.

EXAMPLE 1 - Introduction of Nano-particle Catalysts into Plasma Device

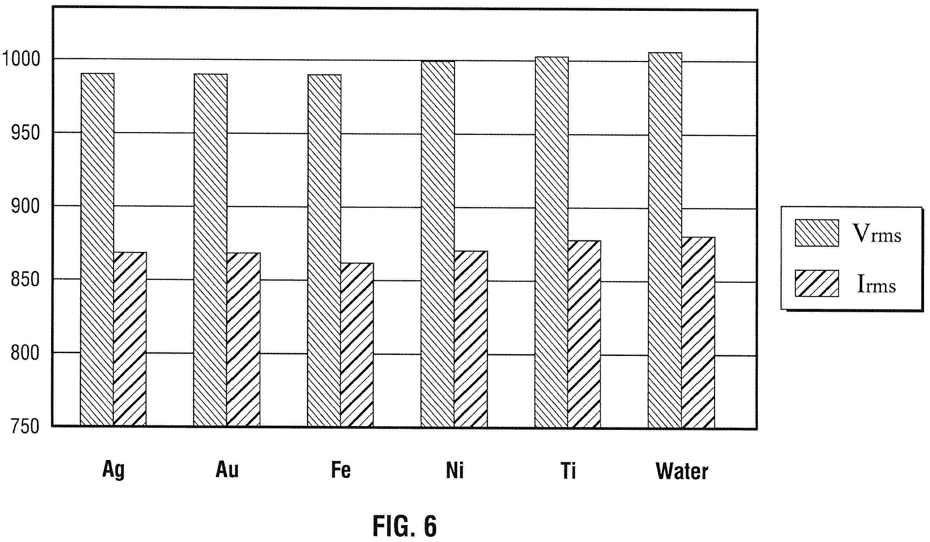

Fig. 6 illustrates a bar graph of voltage and current measurements of the plasma electrodes during plasma generation. The voltage and current were relatively unchanged by the introduction of various catalysts, including silver, gold, iron, nickel, and titanium. Thus, introduction of catalysts does not affect the plasma power or the energy delivered by the plasma.

A hydroxyl emission spectra intensity of the plasma with and without catalyst nano-particles were also obtained. It was noted that generation of OH radicals was about 30% more in the plasma having nano-particle catalysts when compared with plasma generated using only deionized water as a precursor feedstock. It is believed that hydroxyl radicals are more suitable for tissue removal than other radicals generated from halogens, ozone or nitric oxide and the like.

EXAMPLE 2 - Introduction of Nano-particle Catalysts into Plasma Effluent

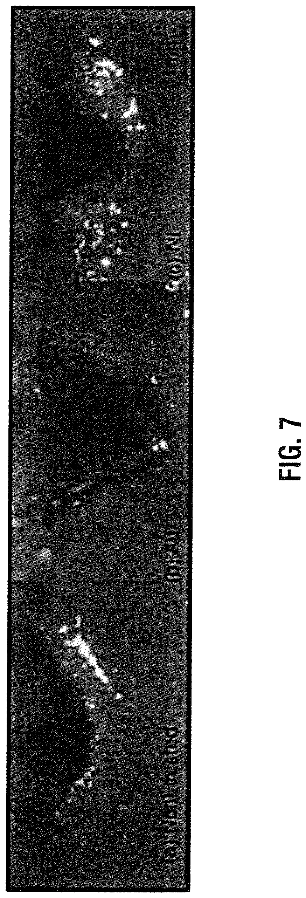

Plasma effluent was generated with and without catalysts. Catalysts materials were gold and nickel nano-particles suspended in an aqueous solution, which was applied to the surface of a tissue sample (chicken muscle tissue). Photographs of removed tissue using a plasma effluent in the absence of catalyst is shown in Fig. 7. Using gold and nickel catalysts resulted in about 100% and about 50% deeper tissue removal as shown in the middle and right photographs of Fig. 7, respectively.

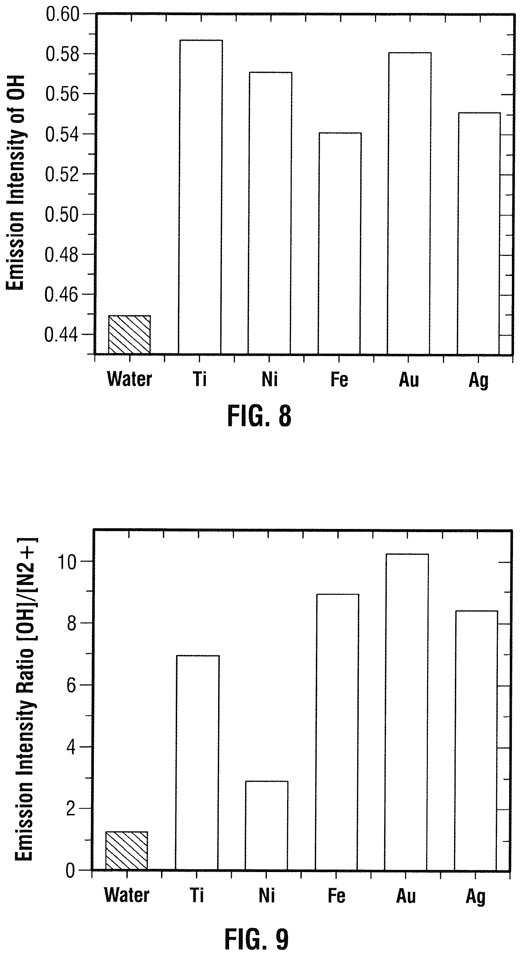

Fig. 8 illustrates hydroxyl emission spectra of the plasma effluent and Fig. 9 illustrates hydroxyl and nitrogen emission spectra of plasma effluent. It was noted that generation of hydroxyl and nitrogen radicals was significantly larger in the plasma having nano-particle catalysts when compared with plasma generated using only deionized water as a precursor feedstock. In particular, use of gold as a catalyst resulted in about five times more hydroxyl radicals than with nickel.

Although the illustrative embodiments of the present disclosure have been described herein with reference to the accompanying drawings, it is to be understood that the disclosure is not limited to those precise embodiments, and that various other changes and modifications may be effected therein by one skilled in the art without departing from the scope or spirit of the disclosure. In particular, as discussed above this allows the tailoring of the relative populations of plasma species to meet needs for the specific process desired on the workpiece surface or in the effluent of the reactive plasma.

## Claims

1. A plasma system (10) comprising:

   a plasma device (12) including at least one electrode;
   an ionizable media source (16) coupled to the plasma device and configured to supply ionizable media thereto;
   a precursor source (18) configured to supply at least one precursor feedstock; and
   a power source (14) coupled to the at least one electrode, wherein either:

      (A) the ionisable media source and the precursor source are coupled to the plasma device via tubing (13a,13b), whereby the precursor source is configured to supply the at least one precursor feedstock to the plasma device; and
      the power source is configured to ignite the ionizable media and the at least one precursor feedstock at the plasma device to form a plasma effluent; or

(B) the power source is configured to ignite the ionizable media at the plasma device to form a plasma effluent;

the precursor source includes a nebulizer (204) configured to nebulize the at least one precursor feedstock to form an aerosol spray (206); and
the plasma device further comprises an applicator (210) coupled to the precursor source, the applicator directing the aerosol spray into the plasma effluent; wherein the plasma system (10) is **characterized in that** the at least one precursor feedstock includes at least one catalyst material (202) selected from the group consisting of ruthenium, rhodium, palladium, silver, osmium, iridium, platinum, gold, nickel, copper, cobalt, iron, and oxides and bimetal combinations thereof.

2. The plasma system according to claim 1, wherein the at least one electrode is formed from a metal alloy selected from the group consisting of an aluminum alloy and a titanium alloy.

3. The plasma system according to claim 1 or 2, wherein the at least one precursor feedstock is selected from the group consisting of a solution, a suspension and a mixture of the at least one catalyst material.

4. The plasma system according to claim 1, alternative (A), wherein the precursor source includes a nebulizer (204) configured to form an aerosol spray of the at least one precursor feedstock.

5. The plasma system according to any preceding claim, wherein the plasma device includes:

an outer electrode (123) having a substantially cylindrical tubular shape defining a lumen therethrough; and
an inner electrode (122) coaxially disposed within lumen, the inner electrode having a substantially cylindrical tubular shape.

6. The plasma system according to any preceding claim, wherein the at least one catalyst material is formed as a plurality of particles.

7. A method for generating plasma in a plasma system according to claim 1, alternative (A), comprising:

supplying the ionizable media to the plasma device;
supplying the at least one precursor feedstock to the plasma device; and

igniting the ionizable media and the at least one precursor feedstock at the plasma device to form a plasma effluent.

8. The method according to claim 7, further comprising: nebulizing the at least one precursor feedstock to form an aerosol spray.

9. A method for generating plasma in a plasma system according to claim 1, alternative (B), comprising:

supplying the ionizable media to the plasma device;
igniting the ionizable media at the plasma device to form a plasma effluent;
nebulizing the at least one precursor feedstock to form an aerosol spray; and
supplying the aerosol spray through the applicator into the plasma effluent.

10. The method according to claim 9, further comprising applying the aerosol spray to a workpiece prior to applying the plasma effluent thereto.

11. The method according to any of claims 7 to 10, wherein the at least one electrode of the plasma device is formed from a metal alloy selected from the group consisting of an aluminum alloy and a titanium alloy.

12. The method according to any of claims 7 to 11, wherein the at least one precursor feedstock is selected from the group consisting of a solution, a suspension and a mixture of the at least one catalyst material.

13. The method according to any of claims 7 to 12, wherein the plasma device includes:

an outer electrode (123) having a substantially cylindrical tubular shape defining a lumen therethrough; and
an inner electrode (122) coaxially disposed within lumen, the inner electrode having a substantially cylindrical tubular shape.

14. The method according to any of claims 7 to 13, wherein the at least one catalyst material is formed as a plurality of particles.

**Patentansprüche**

1. Plasmasystem (10), umfassend:

eine Plasmavorrichtung (12), enthaltend mindestens eine Elektrode;
eine ionisierbare Medienquelle (16), die an die Plasmavorrichtung gekoppelt und konfiguriert ist, dieser ionisierbare Medien zuzuleiten;

eine Vorläuferquelle (18), die konfiguriert ist, mindestens ein Vorläuferausgangsmaterial zuzuleiten; und

eine Leistungsquelle (14), die an die mindestens eine Elektrode gekoppelt ist, wobei entweder:

A) die ionisierbare Medienquelle und die Vorläuferquelle über eine Rohrleitung (13a,13b) an die Plasmavorrichtung gekoppelt sind, wobei die Vorläuferquelle konfiguriert ist, der Plasmavorrichtung das mindestens eine Vorläuferausgangsmaterial zuzuleiten; und

die Leistungsquelle konfiguriert ist, die ionisierbaren Medien und das mindestens eine Vorläuferausgangsmaterial an der Plasmavorrichtung zu zünden, um einen Plasmaeffluenten zu bilden; oder

B) die Leistungsquelle konfiguriert ist, die ionisierbaren Medien an der Plasmavorrichtung zu zünden, um einen Plasmaeffluenten zu bilden;

die Vorläuferquelle einen Zerstäuber (204) enthält, der konfiguriert ist, das mindestens eine Vorläuferausgangsmaterial zu zerstäuben, um einen Aerosolnebel (206) zu bilden; und

die Plasmavorrichtung weiter einen Applikator (210) umfasst, der an die Vorläuferquelle gekoppelt ist, wobei der Applikator den Aerosolnebel in den Plasmaeffluenten lenkt;

wobei das Plasmasystem (10) **dadurch gekennzeichnet ist, dass** das mindestens eine Vorläuferausgangsmaterial mindestens ein Katalysatormaterial (202) enthält, das ausgewählt ist aus der Gruppe bestehend aus Ruthenium, Rhodium, Palladium, Silber, Osmium, Iridium, Platin, Gold, Nickel, Kupfer, Kobalt, Eisen und Oxiden und Bimetallkombinationen davon.

2. Plasmasystem nach Anspruch 1, wobei die mindestens eine Elektrode aus einer Metalllegierung gebildet ist, die ausgewählt ist aus der Gruppe bestehend aus einer Aluminiumlegierung und einer Titanlegierung.

3. Plasmasystem nach Anspruch 1 oder 2, wobei das mindestens eine Vorläuferausgangsmaterial ausgewählt ist aus der Gruppe bestehend aus einer Lösung, einer Suspension und einem Gemisch aus dem mindestens einen Katalysatormaterial.

4. Plasmasystem nach Anspruch 1, Alternative (A), wobei die Vorläuferquelle einen Zerstäuber (204) enthält, der konfiguriert ist, einen Aerosolnebel des mindestens einen Vorläuferausgangsmaterials zu bilden.

5. Plasmasystem nach einem der vorstehenden Ansprüche, wobei die Plasmavorrichtung enthält:

eine Außenelektrode (123) mit einer im Wesentlichen zylindrischen rohrförmigen Form, die ein hindurchgehendes Lumen definiert; und eine Innenelektrode (122), die koaxial innerhalb des Lumens angeordnet ist, wobei die Innenelektrode eine im Wesentlichen zylindrische rohrförmige Form aufweist.

6. Plasmasystem nach einem der vorstehenden Ansprüche, wobei das mindestens eine Katalysatormaterial als eine Vielzahl von Partikeln gebildet ist.

7. Verfahren zum Erzeugen von Plasma in einem Plasmasystem nach Anspruch 1, Alternative (A), umfassend:

Zuleiten der ionisierbaren Medien zur Plasmavorrichtung; Zuleiten des mindestens einen Vorläuferausgangsmaterials zur Plasmavorrichtung; und Zünden der ionisierbaren Medien und des mindestens einen Vorläuferausgangsmaterials an der Plasmavorrichtung, um einen Plasmaeffluenten zu bilden.

8. Verfahren nach Anspruch 7, weiter umfassend: Zerstäuben des mindestens einen Vorläuferausgangsmaterials, um einen Aerosolnebel zu bilden.

9. Verfahren zum Erzeugen von Plasma in einem Plasmasystem nach Anspruch 1, Alternative (B), umfassend:

Zuleiten der ionisierbaren Medien zur Plasmavorrichtung; Zünden der ionisierbaren Medien an der Plasmavorrichtung, um einen Plasmaeffluenten zu bilden; Zerstäuben des mindestens einen Vorläuferausgangsmaterials, um einen Aerosolnebel zu bilden; und Zuleiten des Aerosolnebels durch den Applikator in den Plasmaeffluenten.

10. Verfahren nach Anspruch 9, weiter umfassend Anwenden des Aerosolnebels an einem Werkstück vor Anwenden des Plasmaeffluenten an diesem.

11. Verfahren nach einem der Ansprüche 7 bis 10, wobei die mindestens eine Elektrode der Plasmavorrichtung aus einer Metalllegierung gebildet ist, die ausgewählt ist aus der Gruppe bestehend aus einer Aluminiumlegierung und einer Titanlegierung.

12. Verfahren nach einem der Ansprüche 7 bis 11, wobei das mindestens eine Vorläuferausgangsmaterial ausgewählt ist aus der Gruppe bestehend aus einer Lösung, einer Suspension und einem Gemisch aus dem mindestens einen Katalysatormaterial.

13. Verfahren nach einem der Ansprüche 7 bis 12, wobei die Plasmavorrichtung enthält:

eine Außenelektrode (123) mit einer im Wesentlichen zylindrischen rohrförmigen Form, die ein hindurchgehendes Lumen definiert; und eine Innenelektrode (122), die koaxial innerhalb des Lumens angeordnet ist, wobei die Innenelektrode eine im Wesentlichen zylindrische rohrförmige Form aufweist.

14. Verfahren nach einem der Ansprüche 7 bis 13, wobei das mindestens eine Katalysatormaterial als eine Vielzahl von Partikeln gebildet ist.

**Revendications**

1. Système à plasma (10) comprenant :

un dispositif à plasma (12) incluant au moins une électrode ;
une source de milieu ionisable (16) couplée au dispositif à plasma et configurée pour fournir un milieu ionisable à celui-ci ;
une source de précurseur (18) configurée pour fournir au moins un précurseur de départ ; et
une source d'alimentation (14) couplée à l'au moins une électrode, dans lequel soit :

(A) la source de milieu ionisable et la source de précurseur sont couplées au dispositif à plasma par l'intermédiaire d'une tubulure (13a,13b), moyennant quoi la source de précurseur est configurée pour fournir l'au moins un précurseur de départ au dispositif à plasma ; et
la source d'alimentation est configurée pour allumer le milieu ionisable et l'au moins un précurseur de départ au niveau du dispositif à plasma pour former un effluent de plasma ; ou
(B) la source d'alimentation est configurée pour allumer le milieu ionisable au niveau du dispositif à plasma pour former un effluent de plasma ;
la source de précurseur inclut un nébuliseur (204) configuré pour nébuliser l'au moins un précurseur de départ pour former une pulvérisation d'aérosol (206) ; et
le dispositif à plasma comprend en outre un applicateur (210) couplé à la source de précurseur, l'applicateur dirigeant la pulvérisation d'aérosol dans l'effluent de plasma ;
dans lequel le système à plasma (10) est **caractérisé en ce que** l'au moins un précurseur de départ inclut au moins un matériau de catalyseur (202) choisi dans le groupe constitué de ruthénium, de rhodium, de palladium, de l'argent, de l'osmium, de l'iridium, de platine, de l'or, de nickel, de cuivre, de cobalt, de fer, et d'oxydes et combinaisons bimétalliques de ceux-ci.

2. Système à plasma selon la revendication 1, dans lequel l'au moins une électrode est formée à partir d'un alliage métallique choisi dans le groupe constitué d'un alliage d'aluminium et d'un alliage de titane.

3. Système à plasma selon la revendication 1 ou 2, dans lequel l'au moins un précurseur de départ est choisi dans le groupe constitué d'une solution, d'une suspension et d'un mélange de l'au moins un matériau de catalyseur.

4. Système à plasma selon la revendication 1, variante (A), dans lequel la source de précurseur inclut un nébuliseur (204) configuré pour former une pulvérisation d'aérosol de l'au moins un précurseur de départ.

5. Système à plasma selon l'une quelconque des revendications précédentes, dans lequel le dispositif à plasma inclut :

une électrode externe (123) ayant une forme tubulaire sensiblement cylindrique définissant une lumière à travers celle-ci ; et
une électrode interne (122) disposée de manière coaxiale à l'intérieur de la lumière, l'électrode interne ayant une forme tubulaire sensiblement cylindrique.

6. Système à plasma selon l'une quelconque des revendications précédentes, dans lequel l'au moins un matériau de catalyseur est formé sous la forme d'une pluralité de particules.

7. Procédé de génération de plasma dans un système à plasma selon la revendication 1, variante (A), comprenant :

la fourniture du milieu ionisable au dispositif à plasma ;
la fourniture de l'au moins un précurseur de départ au dispositif à plasma ; et

l'allumage du milieu ionisable et de l'au moins un précurseur de départ au niveau du dispositif à plasma pour former un effluent de plasma.

8. Procédé selon la revendication 7, comprenant en outre :
la nébulisation de l'au moins un précurseur de départ pour former une pulvérisation d'aérosol.

9. Procédé de génération de plasma dans un système à plasma selon la revendication 1, variante (B), comprenant :

   la fourniture du milieu ionisable au dispositif à plasma ;
   l'allumage du milieu ionisable au niveau du dispositif à plasma pour former un effluent de plasma ;
   la nébulisation de l'au moins un précurseur de départ pour former une pulvérisation d'aérosol ; et
   la fourniture de la pulvérisation d'aérosol à travers l'applicateur dans l'effluent de plasma.

10. Procédé selon la revendication 9, comprenant en outre l'application de la pulvérisation d'aérosol sur une pièce à travailler avant l'application de l'effluent de plasma sur celle-ci.

11. Procédé selon l'une quelconque des revendications 7 à 10, dans lequel l'au moins une électrode du dispositif à plasma est formée à partir d'un alliage métallique choisi dans le groupe constitué d'un alliage d'aluminium et d'un alliage de titane.

12. Procédé selon l'une quelconque des revendications 7 à 11, dans lequel l'au moins un précurseur de départ est choisi dans le groupe constitué d'une solution, d'une suspension et d'un mélange de l'au moins un matériau de catalyseur.

13. Procédé selon l'une quelconque des revendications 7 à 12, dans lequel le dispositif à plasma inclut :

   une électrode externe (123) ayant une forme tubulaire sensiblement cylindrique définissant une lumière à travers celle-ci ; et
   une électrode interne (122) disposée de manière coaxiale à l'intérieur de la lumière, l'électrode interne ayant une forme tubulaire sensiblement cylindrique.

14. Procédé selon l'une quelconque des revendications 7 à 13, dans lequel l'au moins un matériau de catalyseur est formé sous la forme d'une pluralité de particules.

FIG. 1

**FIG. 2**

**FIG. 3**

**FIG. 4**

EP 2 765 592 B1

FIG. 5

**FIG. 6**

EP 2 765 592 B1

FIG. 7

FIG. 8

FIG. 9

**EP 2 765 592 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20110101862 A1
- WO 2011123125 A1